## Europäisches Patentamt
## European Patent Office
## Office européen des brevets

(19)

(11) Veröffentlichungsnummer: **0 004 984**
**B1**

(12) # EUROPÄISCHE PATENTSCHRIFT

(45) Veröffentlichungstag der Patentschrift:
**22.12.82**

(51) Int. Cl.³: **H 02 P  9/04**, G 05 D  13/62,
**G 01 R  23/10**

(21) Anmeldenummer: **79200152.1**

(22) Anmeldetag: **29.03.79**

(54) **Schaltung zur Frequenzregelung in elektrischen Energieverteilungsnetzen.**

(30) Priorität: **18.04.78 DE 2816879**

(43) Veröffentlichungstag der Anmeldung:
**31.10.79 Patentblatt 79/22**

(45) Bekanntmachung des Hinweises auf die Patenterteilung:
**22.12.82 Patentblatt 82/51**

(84) Benannte Vertragsstaaten:
**CH FR IT NL SE**

(56) Entgegenhaltungen:
**DE-A-2 125 093**
**DE-A-2 318 875**
**US-A-3 566 250**
**US-A-3 698 829**
**US-A-3 818 342**
**US-A-3 922 670**
**US-A-4 070 618**

**REGELUNGSTECHNIK; Band 16, Nr. 7, Juli 1968,
München, DE, A. WEINMANN: «Erweiterung des
Rücksprungverfahrens für digitale Frequenzregler
durch Steigerung der Messfolge», Seiten 302–305.**

**Prospekt-Siemens:   Leistungs-Frequenzregelung,
(Lastverteilerausrüstungen) Bestell-Nr. E 142/1801.**

(73) Patentinhaber: **Grimm, German, Dipl.-Ing., Am
Feldrain 8, D-8061 Hebertshausen (DE)**

(72) Erfinder: **Grimm, German, Dipl.-Ing., Am Feldrain 8,
D-8061 Hebertshausen (DE)**

(74) Vertreter: **Dorner, Jörg, Dr.-Ing. et al,
Landwehrstrasse 37, D-8000 München 2 (DE)**

Anmerkung: Innerhalb von neun Monaten nach der Bekanntmachung des Hinweises auf die Erteilung des europäischen
Patents im Europäischen Patentblatt kann jedermann beim Europäischen Patentamt gegen das erteilte europäische Patent
Einspruch einlegen. Der Einspruch ist schriftlich einzureichen und zu begründen. Er gilt erst als eingelegt, wenn die
Einspruchsgebühr entrichtet worden ist (Art. 99(1) Europäisches Patentübereinkommen).

## Schaltung zur Frequenzregelung in elektrischen Energieverteilungsnetzen.

Die Erfindung bezieht sich auf eine Schaltung zur Frequenzregelung in elektrischen Energieverteilungsnetzen, mit digitalen Frequenzmesseinrichtungen, Sollwerterzeugungseinrichtungen, Vergleichseinrichtungen und mit deren Ausgang verbundenen Stellmitteln zur Frequenzänderung.

Bekannte Schaltungen dieser Art haben den Nachteil, dass unerwartet rasch auftretende Regelabweichungen erst mit beträchtlicher Verzögerung eine Betätigung des Stelltriebes hervorrufen, so dass bis zum Ansprechen des Reglers sich bereits eine Regelabweichung aufgebaut haben kann, welche nicht zulässig ist. Dies gilt insbesondere für elektrische Energieverteilungsnetze, bei welchen bekanntlich im Falle grosser plötzlicher Frequenzabweichungen die Gefahr eines Netzzusammenbruches besteht.

Bedingung für eine frühzeitige Meldung einer Frequenzabweichung durch die Messeinrichtungen ist eine sehr genaue Messung, welche vorzugsweise digital durchgeführt wird. Hierbei stellt sich aber das Problem, dass das Messergebnis innerhalb eines besimmten Zeitraumes gebildet und dann innerhalb eines weiteren Zeitraumes ausgewertet wird. Tritt während des Auswertzeitraumes eine rasche Frequenzänderung ein, so kann diese nicht sogleich im Messergebnis erfasst und vom Stelltrieb berücksichtigt werden, so dass wiederum eine Verzögerung des Ansprechens des Stelltriebs möglicherweise zu unzulässigen Frequenzabweichungen vom Sollwert führt.

Aus der US-Patentschrift 3 922 670 ist es bekannt, in einer digitalen Frequenzmessschaltung zwei Frequenzmesszweige vorzusehen, welche jeweils Zähler enthalten, denen von einer Schwingung unbekannter Frequenz abgeleitete Impulse zur Bestimmung einer Zählperiode und von einer Bezugsfrequenz abgeleitete Zählimpulse zugeführt werden. Die Zählerstände werden jeweils alternierend abgefragt.

Die Verwendung einer derartigen digitalen Frequenzmessschaltung in einer Schaltung zur Frequenzregelung in elektrischen Energieverteilungsnetzen erscheint nicht möglich oder zumindest nachteilig, da in Energieverteilungsnetzen häufig auftretende, vorübergehende Verzerrungen zur Verschiebung der in der bekannten Schaltung die Zählperioden bestimmenden Impulse führen würden, so dass es insbesondere bei der Frequenzmessung rasch auftretender Störungen zu Fehlmessungen und daher zu fehlerhaften Regelvorgängen käme.

Aus der US-Patentschrift 4 070 618 ist es ferner bekannt, in einer digitalen Frequenzmessschaltung die Messgenauigkeit dadurch zu erhöhen, dass eine von der zu messenden Frequenz durch Frequenzvervielfachung abgeleitete Frequenz zur Festlegung der Zählperioden in einem Zähler dient, welchem Zählimpulse von einem Oszillator zugeführt werden. Auch bei dieser bekannten Schaltung tritt das Problem auf, dass bei einer Verzerrung der Schwingung unbekannter Frequenz von der Messschaltung Frequenzänderungen vorgetäuscht werden.

Durch die Erfindung soll die Aufgabe gelöst werden, eine Frequenzregelschaltung der eingangs kurz beschriebenen Art so auszugestalten, dass aufgrund einer unverfälschten Frequenzmessung ein weitgehend verzögerungsfreies Ansprechen der Regelung auch bei sehr rasch auftretenden Frequenzänderungen, welche mit Verzerrungen der Netzfrequenz einhergehen, erzielt wird.

Diese Aufgabe wird erfindungsgemäss dadurch gelöst, dass die Frequenzmesseinrichtung mindestens zwei Messzweige enthalten, welche in zeitlich aneinander anschliessenden oder einander überlappenden Zeiträumen eine Frequenzmessung vornehmen, wobei die Messzweige jeweils Zähler enthalten, denen Impulse mit einer synthetischen, durch Vervielfachung von der zu messenden Frequenz abgeleiteten Frequenz als Zählimpulse zugeführt werden und denen Zähltakt-Schaltimpulse zur Bestimmung der Zählperioden von einem Zähltaktgenerator zugeführt werden und dass die Vergleichseinrichtungen mit den Messzweigen alternierend bzw. zyklisch verbunden werden.

Man erkennt, dass bei dieser Ausbildung der Frequenzregelschaltung die alternierend abgefragten Zähler in den beiden Frequenzmesszweigen bezüglich ihrer Zählperioden durch einen Taktimpulsgenerator und nicht durch von der Netzfrequenz abgeleitete Impulse gesteuert werden, wodurch Fehlmessungen bei einer Verzerrung der Netzfrequenz ausgeschlossen sind. Dies ist von besonderer Wichtigkeit bei neuartigen, rasch ansprechenden Regelsystemen, welche zu ernsthaften Störungen führenden Frequenzänderungen bereits in der Entstehung entgegenwirken sollen. Aus diesem Grunde ist es sinnvoll, dass die Regelgrösse praktisch zu keinem Zeitpunkt unbeobachtet bleibt, da während der Auswertung des Messergebnisses eines Messzweiges in den Vergleichseinrichtungen bereits ein anderer bzw. der andere Messzweig ein neues Messergebnis bildet, welches unmittelbar anschliessend an den Vergleichseinrichtungen ausgewertet wird.

Die Ableitung der Zählimpulse von der Netzfrequenz durch Frequenzvervielfachung geschieht in vorteilhafter, jedoch an sich bekannter Weise dergestalt, dass die Frequenzmesseinrichtungen einen mit dem Ausgang eines Phasenvergleichers verbundenen spannungsgesteuerten Oszillator enthalten, welcher die genannten Messzweige speist und welcher ausgangsseitig ausserdem an einen Frequenzteiler angeschlossen ist, dessen Ausgangsfrequenz in dem Phasenvergleicher mit der zu messenden Frequenz verglichen wird.

Es sei nochmals darauf hingewiesen, dass die Frequenzmessung mittels der hier angegebenen Stellung gegenüber bekannten Frequenzmessungen durch Bestimmung des zeitlichen Abstandes der Nulldurchgänge der zu untersuchenden Spannung den wesentlichen Vorteil hat, dass vorübergehende Instabilitäten beim Nulldurchgang dieser Spannung nicht das Messergebnis verfälschen und möglicherweise den Regler zum Ansprechen bringen. Vielmehr werden solche vorübergehenden Instabilitäten des Verlaufes der zu untersuchenden Spannung ausgeschieden, ohne dass die Genauigkeit der Messung über die praktisch interessierenden Zeiträume von einer halben Periode der zu untersuchenden Frequenz hinweg leidet.

Die von dem Zähltaktgenerator vorgegebenen Zähltakte und die jeweils zugehörige Zählerlaufgeschwindigkeit können einstellbar sein, so dass die Anzahl der Messungen je Zeiteinheit gewählt werden kann, wobei wegen der entsprechenden Umschaltung der Zählerlaufgeschwindigkeit, etwa durch Umschaltung der Ansteuerung bestimmter Zählerstufen, jeweils grössenordnungsmässig gleiche Zählerstände erreicht werden und infolgedessen in der übrigen Schaltung, beispielsweise in den Sollwerterzeugungseinrichtungen, keine Umstellungen bei einem Wechsel des Zähltaktes vorgenommen werden müssen. Jedenfalls aber wird die Umschaltgeschwindigkeit einer an die Zähler der Messzweige angeschlossenen Multiplexeinrichtung, von deren Ausgang die Vergleichseinrichtung gespeist werden, entsprechend dem jeweils gewählten Zähltakt eingestellt.

Eine bevorzugte praktische Ausführungsform der hier angegebenen Frequenzregelschaltung für elektrische Energieverteilungsnetze, welche als Störfallregler eingesetzt werden kann, um bei plötzlichen Frequenzeinbrüchen Leistungsreserven des Netzes rasch einzusetzen oder das Netz rasch durch Flächenabschaltung von Teilnetzen zu entlasten, sieht vor, dass die Vergleichseinrichtungen einen Proportionalzweig und einen mit diesem zu Stelltriebseinschaltung verknüpften Differentialzweig enthalten und dass an die Messzweigausgänge eine Differenziereinrichtung angeschlossen ist, welche mit dem Differentialzweig der Vergleichseinrichtungen Verbindung hat.

Die Verknüpfung des Proportionalzweiges und des Differentialzweiges der Vergleichseinrichtungen ist vorzugsweise eine UND-Verknüpfung, derart, dass der Stelltrieb im Sinne einer Frequenzerhöhung eingeschaltet wird, wenn der Istwert der Frequenz einen bestimmten Frequenzsollwert unterschreitet und gleichzeitig der Differentialquotient des Istwertes der Frequenz nach der Zeit einen negativen Sollwert oder Grenzwert dieses Differentialquotienten überschreitet.

Die Rückschaltung des Stelltriebes kann mittels eines Signals erfolgen, welches die Rückkehr der gemessenen Frequenz in einen Sollbereich signalisiert, wobei die Abschaltung oder Rückschaltung des Stelltriebs abhängig vom Auftreten dieses Signals zeitverzögert sein kann. Hierdurch wird vermieden, dass ein kurzzeitiger Frequenzanstieg nach der durch die Frequenzregelschaltung veranlassten Zufuhr der Leistungsreserven zur Wiederabschaltung des Stelltriebes führt, bevor sich der Betriebszustand des betreffenden Energieverteilungsnetzes so weit beruhigt hat, dass danach die Frequenz durch die normalen, vergleichsweise langsam arbeitenden Kraftwerksregler gehalten werden kann.

Nachfolgend werden Ausführungsbeispiele unter Bezugnahme auf die Zeichnung näher erläutert. Es stellen dar:

Fig. 1 ein schematisches Blockschaltbild einer Frequenzregelschaltung für elektrische Energieverteilungsnetze und

Fig. 2 ein Blockschaltbild eines Teils einer gegenüber Fig. 1 abgewandelten Schaltung.

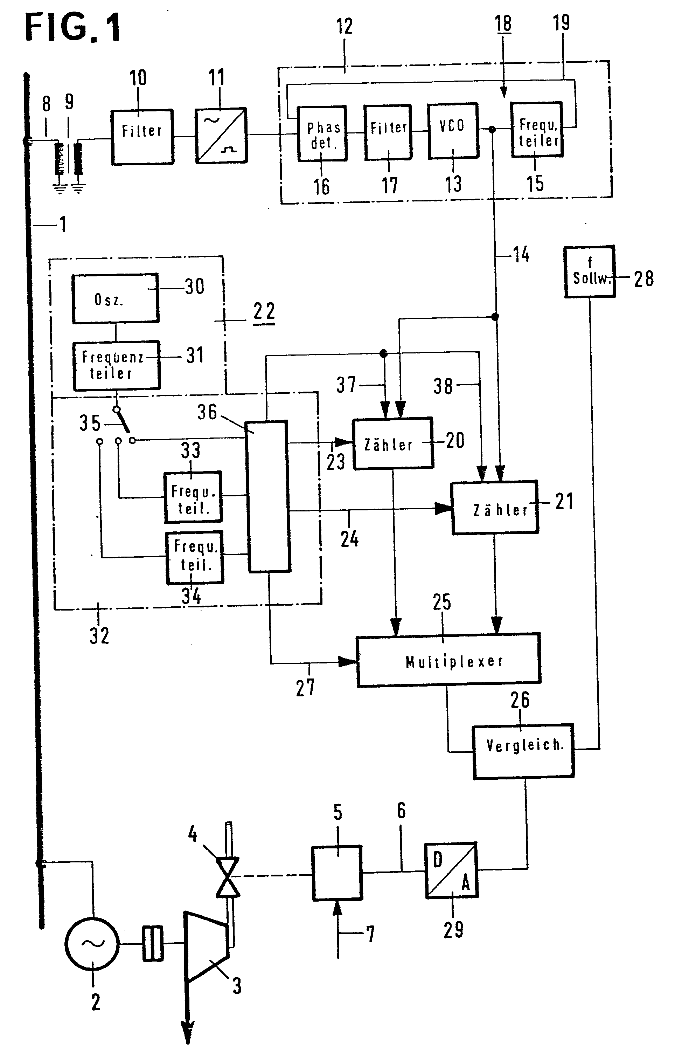

In Figur 1 ist ein elektrisches Energieverteilungsnetz mit 1 bezeichnet. Auf dieses Netz arbeitet ein Turbogenerator 2, welcher von einer Turbine 3 angetrieben wird. Die Leistung der Turbine 3 ist mittels eines Ventils 4 steuerbar, welches durch einen Stelltrieb 5 eingestellt werden kann. Der Stelltrieb 5 ist ein- und ausschaltbar und erzeugt zur Durchführung einer Zweipunktregelung eine Ventilstellung grösserer bzw. kleinerer Öffnung. Die Einschaltung des Stelltriebs 5 erfolgt über einen Eingang 6, während die Wiederausschaltung über einen Eingang 7 vorgenommen werden kann.

Die Frequenz auf dem Netz 1 wird an einer Messstelle 8 untersucht, wobei die Messeinrichtungen vom Netz durch einen Transformator 9 isoliert sind. Die Sekundärspannung des Transformators 9 wird durch einen Filter 10 geführt, um Störungen ausserhalb des Bereiches zu erwartender Frequenzänderungen auszusieben, wonach die im wesentlichen sinusförmige Ausgangsspannung des Filters 10 in einem Umformer 11 in eine Rechteckwelle entsprechender Frequenz umgeformt wird. An den Umformer 11 schliesst sich eine Frequenzmultiplikationseinrichtung 12 an, welche die Aufgabe hat, aus der die zu untersuchende Frequenz aufweisenden Rechteckwellenschwingung eine Signalschwingung mit einer synthetischen Frequenz zu bilden, welche ein Vielfaches der zu untersuchenden Frequenz beträgt, wobei aber die Signalschwingung mit der synthetischen Frequenz zu der Rechteckwellenschwingung synchronisiert gehalten wird und eine bestimmte Phasenbeziehung stets beibehält.

Eine Multiplikationseinrichtung, welche diese Aufgabe erfüllt, enthält einen spannungsgesteuerten Oszillator 13, welcher auf einer Leitung 14 die gewünschte Signalschwingung mit der synthetischen Frequenz abgibt. Die Synchronisation der Ausgangsschwingung des spannungsgesteuerten Oszillators 13 mit der Rechteckwellenschwingung am Ausgang des Umformers 11 wird durch eine einen Frequenzteiler 15, einen Phasendetektor 16 und einen Filter 17 enthaltende Phasenregelschleife erreicht, welche in Fig. 1 allgemein mit 18 bezeichnet ist. Das Teilerverhältnis des Frequenzteilers 15 entspricht dem durch die Multiplikationseinrichtung 12 einzuführenden Frequenzmultiplikationsfaktor. Ist dieser Faktor beispielsweise 10.000 und liegt die zu untersuchende Frequenz des Energieverteilungsnetzes 1 bei 50 Hz, so wird auf der Leitung 14 eine Signalschwingung von etwa 500.000 Hz abgegeben. Das Teilerverhältnis des Frequenzteilers 15 beträgt in diesem Falle 1/10.000, derart, dass über die Leitung 19, welche den Ausgang des Frequenzteilers 15 mit einem Eingang des Phasendetektors 16 verbindet, eine Schwingung von etwa wiederum 50 Hz zum Vergleich mit der Ausgangsschwingung des Umformers 11 in den Phasendetektor 16 eingespeist wird. Der Phasendetektor 16 liefert eine mit einer bestimmten Welligkeit behaftete Gleichspannung einer Grösse, welche vom Phasenunterschied der in den Phasendetektor eingespeisten Wechselspannung abhängig ist. Nach Ausfiltern der Wechselspannungskomponente dieser Phasendetektorausgangsspannung in dem Filter 17 wird die Spannung zur Ansteuerung des spannungsgesteuerten Oszillators 13 verwendet.

Die zuvor beschriebene Einrichtung zur Frequenzmultiplikation zur Erzeugung der Signalschwingung mit der synthetischen Frequenz ist an sich bekannt, wobei aber im vorliegenden Anwendungsfalle in einer Frequenzregelschaltung sich der wesentliche Vorteil einstellt, dass sämtliche Änderungen der zu untersuchenden Frequenz am Messort 8 mit grosser Präzision in der synthetischen Frequenz auf der Leitung 14 wiederkehren und sich das Auflösungsvermögen der Messeinrichtungen entsprechend dem Multiplikationsfaktor der Multiplikationseinrichtungen 12 vergrössert.

Die Signalschwingung mit der synthetischen Frequenz, welche auf der Leitung 14 ansteht, dient zur Ansteuerung zweier parallel geschalteter Zähler 20 und 21. Die Zähltakte der Zähler 20 und 21 werden durch einen Zähltaktgenerator 22 erzeugt und vorgegeben und den Zählern in Gestalt von Schaltimpulsen über die Leitungen 23 und 24 zugeführt. Die Schaltimpulse der Leitungen 23 und 24 befinden sich in Gegenphase, so dass jeweils in einem der Zähler 20 oder 21 jeweils ein bestimmter Zählerstand während eines Zähltaktes aufgebaut wird, während der andere Zähler innerhalb dieses Zähltaktes seinen Zählerstand zur Auswertung anbietet. Während des darauffolgenden Zähltaktes sind dann die Verhältnisse umgekehrt.

Die Auswahl desjenigen Zählers, dessen Zählerstand jeweils ausgewertet werden soll, erfolgt durch einen an die Zählerausgänge angeschlossenen Multiplexer 25, welcher die Zählerausgänge alternierend zur Verbindung mit einem Eingang eines Vergleichers 26 anwählt. Der Zähltaktgenerator 22 liefert über eine Leitung 27 an den Multiplexer 25 entsprechende Steuerimpulse, welche mit den Schaltimpulsen der Leitungen 23 und 24 synchronisiert sind.

Der jeweils andere Eingang des Vergleichers 26 wird mit einem Sollwert beaufschlagt, der in Gestalt einer mit dem Zählerstand der Zähler 20 bzw. 21 vergleichbaren Digitalzahl von Sollwerterzeugungseinrichtungen 28 dargeboten wird. Das Ausgangssignal des Vergleichers 26 ist somit ein digitales Fehlersignal, das nach einer Digital-/Analogumformung in dem Umsetzer 29 zur Einschaltung des Stelltriebs 5 über den Eingang 6 verwendbar ist.

Der Taktimpulsgenerator 22 enthält bei dem Ausführungsbeispiel nach Fig. 1 einen hochstabilen, quarzgesteuerten Oszillator 30, dessen Frequenz mittels des Frequenzteilers 31 auf einen mit der Frequenz des Netzes 1 vergleichbaren Wert herabgesetzt wird. Besitzt der quarzgesteuerte Oszillator 30 beispielsweise eine Frequenz von 409.000 Hz, so kann diese Frequenz durch einen 13 duale Teilerstufen aufweisenden Frequenzteiler auf die Basisfrequenz von 50 Hz herabgesetzt werden.

Ein dem Frequenzteiler 31 nachgeschalteter Wählerabschnitt 32 des Zähltaktgenerators 22 enthält weitere Frequenzteiler 33 und 34, welche ein Teilerverhältnis von 1/10 bzw. 1/100 einführen, so dass mittels eines Wählerschalters 35 entweder die 50 Hz-Ausgangsschwingung des Frequenzteilers 31 oder die 5 Hz-Ausgangsschwingung des Frequenzteilers 33 oder die 0,5 Hz-Ausgangsschwingung des Frequenzteilers 34 zur Speisung eines Schaltimpulsgenerators 36 ausgewählt werden kann. Der Schaltimpulsgenerator 36 liefert die bereits erwähnten Schaltimpulse der Leitungen 23 und 24, ferner die Steuerimpulse der Leitung 27 für den Multiplexer 25 und weitere, den Zählern 20 und 21 zugeführte Steuersignale, welche auf den Leitungen 37 und 38 auftreten und bewirken, dass die Zählgeschwindigkeit der Zähler 20 und 21 auf die jeweilige Stellung des Wählerschalters 35 abgestimmt ist, um im Ergebnis unabhängig von der Stellung des Wählschalters etwa gleichgrosse Zählerstände zu erreichen, was in der Weise geschehen kann, dass durch die Leitungen 37 und 38 eine Auswahl der jeweils durch die Signalschwingung der Leitung 14 beaufschlagten Zählerstufe in Abhängigkeit von der Stellung des Wählerschalters 35 gesteuert wird. Befindet sich also der Wählerschalter in der in Fig. 1 gezeigten Stellung, so baut sich in den Zählern 20 und 21 der zur Auswertung gelangende Zählerstand 100 mal in der Sekunde auf, was 100 Messungen je Sekunde entspricht. Verbindet der Wählerschalter 35 dem Frequenzteiler 31 mit dem Frequenzteiler 33, so werden 10 Messungen je Sekunde durchgeführt und verbindet der Wählerschalter 35 den Frequenzteiler 31 mit dem Frequenzteiler 34, so wird eine Messung je Sekunde durchgeführt. Bei der grössten Messgeschwindigkeit wird also jede einzelne Halbwelle der Frequenz des Netzes 1 auf etwaige Frequenzänderungen untersucht. Die Messeinrichtung ist ganzzeitig tätig, nachdem die Zähler 20 und 21 alternierend arbeiten.

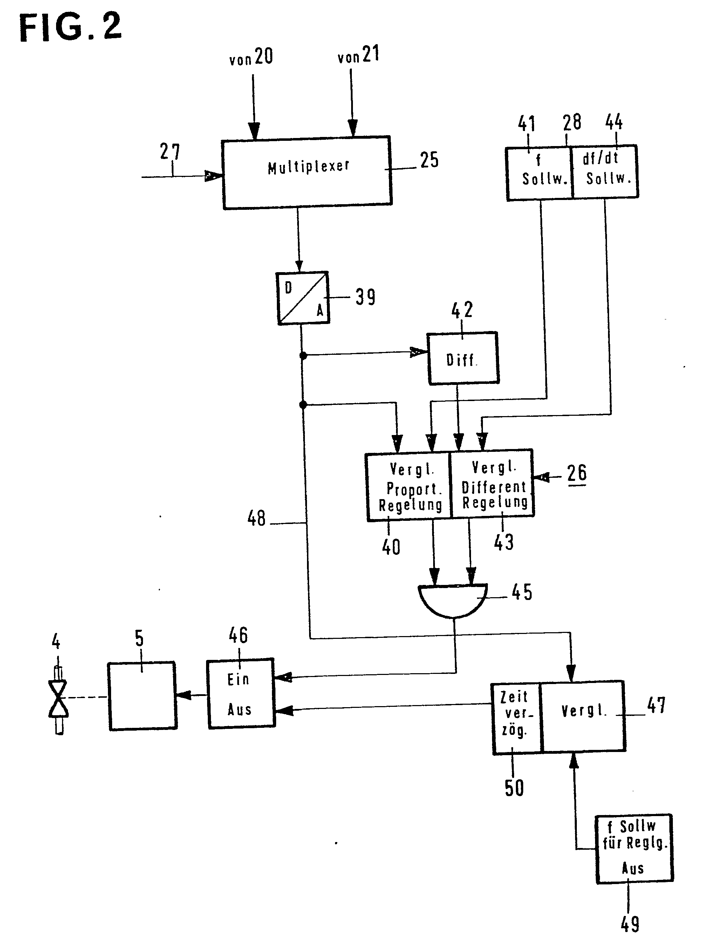

Die Ausführungsform nach Fig. 2 hat mit der Frequenzregelschaltung nach Fig. 1 die an den Multiplexer 25 angeschlossenen Messeinrichtungen und Steuereinrichtungen gemeinsam. Nachdem aber bei der Ausführungsform nach Fig. 2 die Sollwerte als analoge Grössen bereitgestellt werden, wird der Ausgang des Multiplexers 25 bei der vorliegenden Ausführungsform in einem Digital-/Analog-Umsetzer 39 noch vor Einspeisung in die Vergleichseinrichtungen 26 in analoge Form umgesetzt.

Das der Grösse der zu untersuchenden Frequenz entsprechende analoge Ausgangssignal des Umsetzers 39 gelangt einmal zu einem Proportionalzweig 40 der Vergleichseinrichtungen und wird dort mit einem analogen Frequenzsollwert eines Abschnittes 41 der Sollwerterzeugungseinrichtungen 28 verglichen. Zum anderen gelangt das Umsetzerausgangssignal zu einem Differentiator 42, welcher aus dem eingegebenen Analogsignal ein Signal entsprechend dem Differentialquotienten nach der Zeit bildet und dieses in einen Differentialzweig 43 der Vergleichseinrichtungen 26 eingibt. In diesem Differentialzweig erfolgt ein Vergleich des genannten Signales mit einem Sollwert des Differentialquotienten der Frequenz nach der Zeit, welcher vom Ausgang eines Abschnittes 44 der Sollwerterzeugungseinrichtungen 28 abgenommen wird.

Die vom Ausgang der Zweige 40 und 43 der Vergleichereinrichtungen 26 abnehmbaren Fehlersignale oder Vergleichsergebnisse werden einer UND-Verknüpfung in einem UND-Schaltglied 45 unterzogen. Das Ausgangssignal des UND-Schaltelementes 45 dient zur Einschaltung eines den Stelltrieb 5 steuernden Flip-Flops 46, das von einer Ausschaltimpulsquelle 47 rückgestellt wird.

Die Ausschaltimpulsquelle 47 empfängt einerseits über eine Leitung 48 das der zu untersuchenden Frequenz entsprechende Analogsignal vom Ausgang des Digital-/Analogumsetzers 39 und andererseits ein Frequenzsollwertsignal einer Sollwertquelle 49. Es versteht sich, dass der Sollwert des Abschnittes 41 der Sollwerterzeugungseinrichtungen 28 unter demjenigen der Sollwertquelle 49 liegt, um einen bestimmten Abstand der Schaltpunkte der Zweipunktregelung vorzugeben. Ein Zeitverzögerungselement 50 bewirkt eine verzögerte Weiterleitung der Ausschaltbedingung an das Flip-Flop 46, damit nach einem Einschalten des Stelltriebs 5 dieser ausreichend lange in Einschaltstellung verbleibt, um die Leistungsreserven dem Netz 1 zu dessen Stabilisierung ausreichend lange zuführen zu können.

Durch geeignete Ausbildung der Schaltungsbauteile 47 und 50, ggf. durch eine nochmalige UND-Verknüpfung der Ausgangssignale dieser Bauteile, ist dafür Sorge getragen, dass bei einem neuerlichen Frequenzabfall unter den Sollwert der Einrichtung 49 während der Verzögerungszeit des Elementes 50 das Reglerausschaltsignal zurückgehalten wird, so dass der Regler jedenfalls erst dann ausgeschaltet wird, wenn während der gesamten Verzögerungszeit die Frequenz über dem Sollwert gelegen ist.

**Patentansprüche**

1. Schaltung zur Frequenzregelung in elektrischen Energieverteilungsnetzen, mit digitalen Frequenzmesseinrichtungen, Sollwerterzeugungseinrichtungen (28), Vergleichseinrichtungen (26) und mit deren Ausgang verbundenen Stellmitteln (5) zur Frequenzänderung, dadurch gekennzeichnet, dass die Frequenzmesseinrichtungen mindestens zwei Messzweige enthalten, welche in zeitlich aneinander anschliessenden oder einander überlappenden Zeiträumen eine Frequenzmessung vornehmen, wobei die Messzweige jeweils Zähler (20, 21) enthalten, denen Impulse mit einer synthetischen, von der zu messenden Frequenz durch Vervielfachung abgeleiteten Frequenz zugeführt werden und denen Zähltakt-Schaltimpulse zur Bestimmung der Zählperioden von einem Zähltaktgenerator (22) zugeführt werden und dass die Vergleichseinrichtungen (26) mit den Messzweigen alternierend bzw. zyklisch verbunden werden (25).

2. Schaltung nach Anspruch 1, dadurch gekennzeichnet, dass die Frequenzmesseinrichtungen einen die synthetische Frequenz liefernden, mit dem Ausgang eines Phasenvergleichers (16) verbundenen, spannungsgesteuerten Oszillator (13) enthalten, welcher die genannten Messzweige (20, 21) speist und welcher ausgangsseitig ausserdem an einen Frequenzteiler (15) angeschlossen ist, dessen Ausgangsfrequenz in dem Phasenvergleicher mit der zu messenden Frequenz verglichen wird.

3. Schaltung nach Anspruch 1 oder 2, dadurch gekennzeichnet, dass die Zähltakt-Schaltimpulse des Zähltaktgenerators (22) zur Bestimmung der Zählperioden wählbar (35) sind.

4. Schaltung nach Anspruch 3, dadurch gekennzeichnet, dass die Zählerlaufgeschwindigkeit mittels des Zähltaktgenerators (22) entsprechend den gewählten Zählperioden, insbesondere durch Auswahl einer jeweils zu speisenden Zählerstufe, einstellbar (37, 38) ist.

5. Schaltung nach Anspruch 3 oder 4, dadurch gekennzeichnet, dass an die Zähler (20, 21) eine mit den Zähltakt-Schaltimpulsen synchronisierte (27) Multiplexeinrichtung (25) angeschlossen ist, welche mit einem Eingang der Vergleichseinrichtungen (26) verbunden ist.

6. Schaltung nach den Ansprüchen 3 bis 5, dadurch gekennzeichnet, dass die Schaltgeschwindigkeit der Multiplexeinrichtung (25) entsprechend den gewählten Zählperioden einstellbar (27) ist.

7. Schaltung nach einem der Ansprüche 1 bis 6, dadurch gekennzeichnet, dass die Vergleichseinrichtungen (26) einen Proportionalzweig (40) und einen Differentialzweig (43) enthalten, dass die das jeweilige Vergleichsergebnis des Proportionalzweiges und des Differentialzweiges liefernden Ausgänge zur Erzeugung eines Stelltriebeinschaltsignales einer UND-Verknüpfung (45) unterzogen werden und dass an die Messzweigausgänge eine Differenziereinrichtung (42) angeschlossen ist, welche mit dem Differentialzweig der Vergleichseinrichtungen (26) Verbindung hat.

8. Schaltung nach Anspruch 7, dadurch gekennzeichnet, dass die Stelltriebrückschaltung mittels eines Signales erfolgt, welches die Rückkehr der zu messenden Frequenz in einen bestimmten Sollbereich signalisiert (47) und dass die Abschaltung des Stelltriebs abhängig vom Auftreten dieses Signales zeitverzögert (50) ist.

9. Schaltung nach Anspruch 8, dadurch gekennzeichnet, dass eine die Rückkehr der Frequenz in den Sollbereich signalisierende Schaltung (47) und eine die Stelltriebsrückschaltung verzögernde Schaltung (50) so ausgebildet und verbunden sind, dass bei neuerlicher Frequenzabweichung aus dem Sollwertbereich während der Verzögerungszeit der Verzögerungsschaltung (50) das Stelltriebrückschaltsignal zurückgehalten wird, bis eine vollständige Verzögerungszeit ungestört abgelaufen ist.

**Claims**

1. A circuit for automatic frequency control, particularly in power distributing systems, comprising digital frequency-measuring means, set point-generating means, comparators and frequency-changing final control means connected to the output terminal of the comparators, characterized in that the frequency-measuring means comprise in known manner at least two measuring branches (20, 21), which effect a frequency measurement in intervals of time which directly follow each other or overlap each other, the measuring branches contains also in a manner known per se respective counters, which are supplied with pulses at a synthesized frequency, which has been derived by multiplication from the frequency to be measured, and which are supplied from a counter control clock (22) with counting clock switching pulses for determining the counting steps, and the comparators (26) are connected (25) to the measuring branches in alternation or cyclically.

2. A circuit according to claim 1, characterized in that the frequency-measuring means comprise a voltage-controlled oscillator (13), which supplies the synthesized frequency and is connected to the output terminal of a phase comparator (16) and feeds said measuring branches (20, 21) and at its output side is also connected to a frequency divider (15), the output frequency of which is compared in the phase comparator with the frequeny which is to be measured.

3. A circuit according to claim 1 or 2, characterized in that the counting step switching pulses of the counter control clock (22) for controlling the counting steps are adapted to be selected (35).

4. A circuit according to claim 3, characterized in that the counting rate of the counter is adapted to be adjusted (37, 38) by means of the counter control clock (22) in accordance with the selected counting periods, particularly by the selection of a counter stage which is to be fed at a time.

5. A circuit according to claim 3 or 4, characterized in that a multiplexer (25) which is synchronized (27) with the counting step switching pulses succeeds the counters (20, 21) and is connected to one input of the comparators (26).

6. A circuit according to claims 3 to 5, characterized that the switching rate of the multiplexer (25) is adjustable (27) in accordance with the selected counting periods.

7. A circuit according to any of claims 1 to 6, characterized in that the comparators (26) comprise a proportional branch (40) and a differential branch (43), the output terminals delivering the result of the comparisons in the proportional branch and differential branch, respectively, are subjected to an AND operation (45) for generating a signal for enabling the actuator, a differentiator (42) is connected to the output terminals of the measuring branches and to the differential branch of the comparators (26).

8. A circuit according to claim 7, characterized in that the actuator is reset by means of a signal which indicates (47) that the frequency to be measured has returned to a certain desired range, and the disabling of the actuator is delayed (50) in dependence on the occurrence of that signal.

9. A circuit according to claim 8, characterized in that a circuit (47) which indicates that the frequency has returned to the desired range and a circuit (50) for delaying the resetting of the actuator are so designed and connected that in case of a renewed excursion of the frequency from the desired range during the delay time of the delay circuit (50) the signal for resetting the actuator is held back until a complete delay time has elapsed without a disturbance.

**Revendications**

1. Dispositif de réglage des fréquences, particulièrement dans les réseaux de distribution d'énergie électrique, comportant des dispositifs de mesure numérique des fréquence, des générateurs de valeur de consigne, des dispositifs de comparaison et des organes à commander reliés à la sortie des dispositifs de comparaison, et permettant de modifier les fréquences, caractérisé en ce que les dispositifs de mesure des fréquences comportent, de manière connue en soi, au moins deux canaux de mesure (20, 21) qui effectuent une mesure de fréquence dans des intervalles temporaires consécutifs ou se chevauchant, les canaux de mesure comportant chacun également de manière connue en soi, des compteurs auxquels on envoie, à partir d'un générateur de cycles de comptage (22), des impulsions suivant une fréquence calculée dérivée par multiplication de la fréquence à mesurer et des impulsions de commande du cycle de comptage pour la détermination des périodes de comptage et en ce que les dispositifs de comparaison (26) sont reliés (25) avec les canaux de mesure de manière alternée ou cyclique.

2. Dispositif suivant la revendication 1 caractérisé en ce que les dispositifs de mesure des fréquences comportent un oscillateur (13) donnant la fréquence calculée, relié à la sortie d'un comparateur de phases (16) et commandé en tension, oscillateur qui alimente lesdits canaux de mesures (20, 21) et qui est en outre connecté, à sa sortie, à un diviseur de fréquence (15), dont la fréquence de sortie est comparée avec la fréquence à mesurer dans le comparateur de phases.

3. Dispositif suivant les revendications 1 ou 2 caractérisé en ce que les impulsions de commande du cycle de comptage provenant du générateur de cycles de comptage (22) peuvent être choisies (35) pour la détermination des périodes de comptage.

4. Dispositif suivant la revendication 3 caractérisé en ce que la vitesse de comptage du compteur peut être réglée (37, 38) au moyen du générateur de cycles de comptage (22) suivant les périodes de comptage choisies, particulièrement par le choix d'un étage du compteur à mémoriser.

5. Dispositif suivant la revendication 3 ou 4 caractérisé en ce qu'un dispositif de multiplexage (25) synchronisé (27) sur les impulsions de commande du cycle de comptage est raccordé aux compteurs (20, 21), le dispositif de multiplexage étant relié avec une entrée du dispositif de comparaison (26).

6. Dispositif suivant les revendications 3 à 5 caractérisé en ce que la vitesse de commutation du dispositif de multiplexage (25) peut être réglée (27) en fonction des périodes de comptage choisies.

7. Dispositif suivant une des revendications 1 à 6 caractérisé en ce que les dispositifs de comparaison (26) comportent un canal de signal proportionnel (40) et un canal de signal différentiel (43), en ce que les sorties donnant le résultat de comparaison du canal de signal proportionnel et du canal de signal différentiel sont soumises à une porte-ET (45) afin de générer un signal de commande de mise en marche et en ce qu'un dispositif de dérivation (42) est raccordé aux sorties des canaux de mesure, le dispositif de dérivation étant relié au canal de signal différentiel du dispositif de comparaison (26).

8. Dispositif suivant la revendication 7 caractérisé en ce que l'arrêt de l'organe à commander est effectué au moyen d'un signal qui indique (47) le retour de la fréquence à mesurer dans un certain intervalle de consigne et en ce que la coupure de l'organe à commander est retardée (50) en fonction de ce signal.

9. Dispositif suivant la revendication 8 caractérisé en ce qu'un circuit (47) indiquant le retour de la fréquence dans l'intervalle de consigne et un circuit (50) retardant l'arrêt de l'organe à commander sont reliés de manière telle que pour une nouvelle déviation de la fréquence en-dehors de l'intervalle de consigne pendant la durée du retard du dispositif de retardement (50), le signal d'arrêt de l'organe à commander est retenu jusqu'à ce qu'une durée complète du retard se soit écoulée sans avoir été gênée.

FIG.1

0004984

FIG.2